(19) Europäisches Patentamt
European Patent Office
Office européen des brevets

(11) EP 0 452 945 B1

(12) **EUROPEAN PATENT SPECIFICATION**

(45) Date of publication and mention of the grant of the patent:
**17.01.1996 Bulletin 1996/03**

(51) Int Cl.[6]: **H01B 3/12**, C04B 35/00

(21) Application number: **91106263.6**

(22) Date of filing: **18.04.1991**

(54) **Dielectric ceramics**

Dielektrische Keramiken

Céramiques diélectriques

(84) Designated Contracting States:
**DE FR GB**

(30) Priority: **19.04.1990 JP 103491/90**
**25.09.1990 JP 255792/90**

(43) Date of publication of application:
**23.10.1991 Bulletin 1991/43**

(73) Proprietor:
**MATSUSHITA ELECTRIC INDUSTRIAL CO., LTD.**
**Kadoma-shi, Osaka-fu, 571 (JP)**

(72) Inventors:
- **Fujimaru, Takuya**
  **Sadohara-cho, Miyazaki-gun, Miyazaki-ken (JP)**
- **Nishida, Masamitsu**
  **Osaka-shi, Osaka (JP)**
- **Kugimiya, Koichi**
  **Toyonaka-shi, Osaka (JP)**

(74) Representative: **Schwabe - Sandmair - Marx**
**D-81677 München (DE)**

(56) References cited:
**DD-A- 274 816** **US-A- 4 121 941**
**US-A- 4 731 207**

- **PATENT ABSTRACTS OF JAPAN, unexamined applications, E section, vol. 2, no.96, August 11, 1978, THE PATENT OFFICE JAPANESE GOVERNMENT, p. 4594 E 78.**
- **PATENT ABSTRACTS OF JAPAN, unexamined applications, E field, vol.12, no.196, May 10, 1989, THE PATENT OFFICE JAPANESE GOVERNMENT, p.152 E 755.**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 452 945 B1

## Description

1. Field of the Invention:

The present invention relates to dielectric ceramics, and more particularly to dielectric ceramics having high unloaded Q (reciprocal of dielectric loss) in high frequency ranges such as microwaves, millimetric waves, etc.

2. Description of the Prior Art:

Generally, high-frequency dielectric ceramics are widely used as dielectric resonators, substrates for monolithic integrated circuits (MICs), etc.

In recent years, the frequency range used has been expanding to a higher range as the satellite broadcasting and satellite communications using the super high frequency band (SHF band) enters an era of practical use, which has spurred the need for the development of dielectric ceramics having a higher unloaded Q.

Ba-Mg-Ta based dielectric ceramics (as disclosed in USP No. 4121941, USP No. 4487842, USP No. 4731207, Japanese Laid-Open Patent Publication No. 61-181008, and Japanese Laid-Open Patent Publication No. 62-170102 have been drawing attention as dielectric ceramics having a high unloaded Q.

High-frequency dielectric ceramics containing a Ba-Mg-Ta based complex perovskite compound as the main component have poor sintering characteristics. Therefore, in the conventional Ba-Mg-Ta system, it has only been possible to obtain a low unloaded Q of 3,740 to 3,920 at the frequency of 11GHz (USP No. 4121941).

In view of the above difficulty, there has been proposed a method which comprises adding Mn as a sintering agent to improve the sintering characteristics (USP No. 4487842). This method, indeed, is capable of producing dielectric ceramics having an unloaded Q of 10,000 or larger (at frequency of 11GHz), but adding such a dissimilar element as Mn not only leads to complication of the manufacturing process but also entails the possibility of causing a detrimental effect on the dielectric properties of the ceramics because of the addition of such an agent.

Furthermore, there has been proposed a special sintering method called a rapid heating method (a method capable of heating up quickly to the desired temperature) aiming at improving the sintering characteristics (USP No. 4731207). With this method, it is possible to improve the unloaded Q factor, but because of the difference in thermal contraction between the exterior and interior of the ceramics and other reasons, the reproducibility of unloaded Q is particularly poor, making it difficult to obtain products of stable quality. To deal with this problem, a method has been proposed which comprises covering the compact with refractory powder during heating and sintering (Japanese Laid-Open Patent Publication No. 61-181008), but it cannot be said that this method succeeded in basically solving the problem.

When Ba is denoted as A, Mg as B1 and Ta as B2, for example, the oxide of a complex perovskite structure can be represented by the formula A (B1, B2) $O_3$.

In dielectric ceramics containing the oxide of a complex perovskite structure as the main component, it is known that when the crystal structure is hexagonal, the structure takes the shape of periodic arrangement (long-range periodic arrangement) repeating over a wide range with three layers as one cycle, i.e. in the order of B1-B2-B2 in the above formula; therefore, the lattice contracts along the direction perpendicular to the (111) direction, causing strain.

It is also said that the unloaded Q factor is improved as the lattice strain is caused, as described above, as a result of the improved regularity of the long-range periodic arrangement. Therefore, in order to improve the regularity and obtain ceramics having high unloaded Q, it has been the usual practice to sinter ceramics prepared from fine powder of a mean crystal grain size of 1 to 2 pm, followed by over-100 hours sintering and over-100 hours heat treatment.

However, such a sintering method has had the disadvantage of an increased sintering cost and a complicated manufacturing process, thus presenting obstacles to the improvement of production efficiency (S. Kawashima et al., J. Am. Ceram. Soc., 66(6) pp421-(1983)).

Also, when the rapid heating method is used to obtain ceramics of high density and heat treatment of extremely long duration is performed to enhance the regularity, it is possible to obtain ceramics of high unloaded Q, but such a technique also has had the shortcomings of complicating the manufacturing process and presenting obstacles to the improvement of production efficiency (Japanese Laid-Open Patent Publication No. 62-170102).

## SUMMARY OF THE INVENTION

The dielectric ceramic of the present invention, which overcomes the above-discussed and numerous other disadvantages and deficiencies of the prior art, contains as its main component the oxide of a complex perovskite structure and having a mean crystal grain size of sintered ceramic controlled to within the range of 5 μm to 20 μm and a porosity not exceeding 7%, the oxide of the complex perovskite structure consisting essentially of a compound represented by the formula: $uBaO \cdot v[xMgO, (1-x)ZnO] \cdot w[yNb_2O_5, (1-y)Ta_2O_5]$, wherein $0 \leqq x \leqq 1$, $0 \leqq y \leqq 1$, $0.585 \leqq u \leqq 0.620$, $0.160 \leqq v \leqq 0.220$, $0.195 \leqq w \leqq 0.220$, and $u+v+w=1$.

In an embodiment, the oxide of the complex perovskite structure consists essentially of a compound represented by the formula: Ba $[(Mg_x Zn_{1-X})_{1/3}(Nb_y Ta_{1-y})_{2/3}] O_3$, wherein $0 \leqq x \leqq 1$, $0 \leqq y \leqq 1$.

Alternatively, the dielectric ceramic of the present invention contains as its main component a complex perovskite compound consisting essentially of BaO, MgO, and $Ta_2O_5$, the composition range thereof being in the range of 48.1 to 48.8% by weight for BaO and in the range of 3.6 to 4.5% by weight for MgO, and the remaining percentage for $Ta_2O_5$ in the range of 46.7 to 48.3% by weight.

Alternatively, the dielectric ceramic of the present invention contains as its main component a complex perovskite compound consisting essentially of BaO, MgO, and $Ta_2O_5$, the composition range thereof being in the range of 48.3 to 48.8% by weight for BaO and in the range of 3.8 to 4.3% by weight for MgO, and the remaining percentage for $Ta_2O_5$ in the range of 46.9 to 47.7% by weight.

Thus, the invention described herein makes possible the following objectives:

(1) The present invention stably provides high-frequency dielectric ceramics which contains the oxide of a complex perovskite structure as the main component and provides high unloaded Q, overcoming the above-discussed shortcomings, that is, without requiring long-hour sintering or heat treatment.

(2) The present invention provides dielectric ceramics which contain the oxide of a complex perovskite structure as the main component, and in the sintered ceramics, the mean crystal grain size is controlled to within the range of 5 μm to 20 μm and the porosity not exceeding 7%; therefore, unlike conventional dielectric ceramics, there is no need to perform sintering for long hours to regulate B1 and B2 ions and cause the lattice strain. As a result, a drastic reduction can be achieved in manufacturing costs including energy costs, and in the material properties, dielectric ceramics having a higher unloaded Q than the conventional ones can be manufactured stably. These effects are obtained by use of the dielectric ceramics according to the invention having as the main component an oxide represented by the formula $uBaO \cdot v[xMgO, (1-x)ZnO] \cdot w[yNb_2O_5, (1-y) Ta_2O_5]$, wherein $0 \leqq x \leqq 1$, $0 \leqq y \leqq 1$, $0.585 \leqq u \leqq 0.620$, $0.160 \leqq v \leqq 0.220$, $0.195 \leqq w \leqq 0.220$, and $u+v+w=1$. Such effects are especially remarkable in the dielectric ceramics containing as the main component the oxide of the complex perovskite structure represented by the formula $Ba[(Mg_x Zn_{1-x})_{1/3}(Nb_y Ta_{1-y})2/3]O_3$, wherein $0 \leqq x \leqq 1$, $0 \leqq y \leqq 1$.

(3) Using dielectric ceramics according to the invention which contain a complex perovskite compound as the main component and are therefore hard to sinter, dielectric ceramics having a stable quality and a high unloaded Q can be manufactured by a conventional sintering method without using a sintering agent or a special sintering technique and without requiring a long-hour heat treatment.

## BRIEF DESCRIPTION OF THE DRAWINGS

This invention may be better understood and its numerous objects and advantages will become apparent to those skilled in the art by reference to the accompanying drawings as follows:

Figure 1 is a diagram showing the relationship between the sintering temperature, mean crystal grain size, unloaded Q, and degree of regularity concerning samples prepared in accordance with one embodiment of the dielectric ceramics of the present invention;

Figure 2 is a diagram showing the X-ray diffraction patterns of (422) and (226) planes of the powder samples of Figure 1 treated at typical sintering temperatures.

Figure 3 is a diagram showing the relationship between the sintering time, mean crystal grain size, unloaded Q, and degree of regularity concerning samples prepared in accordance with another embodiment of the dielectric ceramics of the present invention;

Figure 4 is a diagram showing the X-ray diffraction patterns of (422) and (226) planes of the powder samples of Figure 3 treated at typical sintering times; and

Figure 5 is a triangular diagram showing the composition range of the dielectric ceramics according to a third embodiment of the present invention.

DESCRIPTION OF THE PREFERRED EMBODIMENTS

Example 1

High purity $BaCO_3$, MgO, $Ta_2O_5$, ZnO, and $Nb_2O_5$ were weighed out so that the ceramics of the compositions I and II shown in Table 1 could be obtained, and the thus weighed materials were wet-mixed using a ball mill.

The resulting mixture was pre-sintered at 1,000 to 1,200°C for two hours, after which the mixture was wet-ground using a ball mill, followed by dehydration and drying.

After that, a binder was added to the resulting powder to control the grain size thereof, and the thus prepared powder was dry-pressed at a pressure of 1,000 $kg/cm^2$ to form into a disk with a diameter of 7.5 mm and a thickness of 4.0 mm. The thus formed compacts were then sintered under the sintering conditions (at a heating/cooling rate of 200°C/h) as shown in Table 1 to produce the sample ceramics.

Table 1-1 shows the compositions and the mean crystal grain size and porosity obtained under each sintering condition. In the table, the sample numbers marked with "*" indicate the samples outside the scope of the present invention.

Table 1-1

| Composition | Sample Nos | Sintering temperature-sintering hour | mean crystal grain size (μm) | Porosity (%) |
|---|---|---|---|---|
| I | *1 | 1550°C - 2h | 1.5 | 1.6 |
| | *2 | 1580°C - 2h | 2.0 | 2.2 |
| | 3 | 1590°C - 2h | 12.5 | 2.7 |
| | 4 | 1600°C - 2h | 17.5 | 2.8 |
| | *5 | 1350°C 120h | 1.3 | 1.1 |
| II | *6 | 1600°C - 2h | 0.1 | 1.4 |
| | *7 | 1600°C - 4h | 1.0 | 1.3 |
| | 8 | 1600°C - 6h | 6.0 | 1.5 |
| | 9 | 1600°C - 12h | 9.5 | 1.8 |
| | 10 | 1600°C - 24h | 15.0 | 2.0 |
| | *11 | 1600°C - 120h | 24.0 | 8.5 |
| | *12 | 1600°C - 1h + 1450°C 120h | 0.1 | 1.0 |

Composition I is $Ba[Zn_{1/3}(Nb_{0.17}Ta_{0.83})_{2/3}]O_3$, and Composition II is $Ba_{0.99}(Mg_{1/3}Ta_{2/3})O_n$ (n; arbitrary number.)

The mean crystal grain size was obtained by the line intercept method using an optical photomicroscope of a ceramic cross section which was chemically etched after being polished to a mirror surface. The porosity was obtained by calculation from the density of an actual sample and a theoretical density calculated from the crystal lattice constant obtained by X-ray diffraction.

Table 1-2 shows the degree of regularity and the electrical characteristics. In the table, the sample numbers marked with "*" indicate the samples outside the scope of the present invention.

Table 1-2

| Composition | Sample Nos | Degree of regularity | unloaded Q | Relative dielectric constant εr | Temperature characteristic τf (ppm/°C) |
|---|---|---|---|---|---|
| I | *1 | 2.25 | 10100 | 31.0 | 1.1 |
| | *2 | 2.15 | 12200 | 30.8 | 1.2 |
| | 3 | 2.00 | 17800 | 30.5 | 0.8 |
| | 4 | 1.80 | 20000 | 30.5 | 0.7 |
| | *5 | 3.21 | 13100 | 30.9 | 1.0 |

Continuation of the Table on the next page

Table 1-2 (continued)

| Composition | Sample Nos | Degree of regularity | unloaded Q | Relative dielectric constant εr | Temperature chracteristic τf (ppm/°C) |
|---|---|---|---|---|---|
| II | *6 | 8.06 | 18000 | 25.4 | 4.6 |
| | *7 | 8.05 | 18400 | 25.4 | 4.3 |
| | 8 | 8.06 | 22000 | 25.1 | 4.5 |
| | 9 | 8.07 | 25000 | 25.1 | 4.5 |
| | 10 | 8.05 | 27000 | 24.9 | 3.9 |
| | *11 | 8.06 | 16300 | 21.3 | 15.3 |
| | *12 | 8.06 | 19600 | 25.5 | 4.8 |

The relative dielectric constant (ε r), unloaded Q, and temperature characteristic (τf) of resonant frequency shown for each sample ceramic are the values measured after polishing the sample to give a resonant frequency of 10GHz to 12GHz. The temperature characteristic (τf) of resonant frequency is the variation of the resonant frequency against the variation of the sample temperature.

The degree of regularity was calculated using the following equation.

$$\text{Degree of regularity} = \frac{(I_{100})}{(I_{100,102})} \times 100$$

In the above equation, ($I_{100}$) represents the intensity of the diffraction line from (100) plane, which is the strongest diffraction line of the superlattice lines appearing as a result of the regularity, and ($I_{110\ 102}$) represents the intensity of the diffraction line from (110, 102) plane, which is the strongest diffraction line of the diffraction lines observed regardless of the presence or absence of the regularity. This means that a higher state of the regularity is achieved as the degree of regularity becomes higher.

Figure 1 shows the relationship between the sintering temperature, mean crystal grain size (dotted line), unloaded Q (solid line), and degree of regularity (dashed line) of the samples No. 1 to No. 4.

Figure 2 shows the results of the examination by X-ray diffraction on the lattice strain associated with the degree of regularity. Figure 2 shows the X-ray diffraction patterns of (422), (226) planes of the samples of Figure 1 (sintered under typical sintering conditions). In the X-ray diffraction analysis, in order to evaluate the deviation of the c/a (c: lattice constant of c-axis, a: lattice constant of a-axis) from $(3/2)^{1/2}$, the diffraction line from the corresponding (422) plane was observed in terms of separation from the diffraction line from (226) plane. It can be seen from the diffraction patterns that if the lattice is not strained, the c/a is equal to $(3/2)^{1/2}$, with the diffraction line from (422) plane coinciding with the diffraction line from (226) plane, and if the lattice is strained, the c/a deviates from $(3/2)^{1/2}$, with the diffraction line from (422) plane separating from the diffraction line from (226) plane, providing a higher unloaded Q.

Figure 3 shows the relationship between the sintering time, mean crystal grain size (dotted line), unloaded Q (solid line), and degree of regularity (dashed line) of the samples No. 6 to No. 11.

Figure 4 shows the X-ray diffraction patterns of (422), (226) planes of the samples of Figure 3 sintered for typical sintering times.

As can be seen from Figure 1, the unload Q dramatically improves at sintereing temperatures between 1,580°C and 1,590°C and reaches 20,000 at 1,600°C. On the other hand, the degree of regularity decreases with increasing sintering temperature, and the separation between (422) and (226) representing the lattice strain shown in Figure 2 becomes less noticeable as the sintering temperature rises. At 1,600°C, almost no separation can be observed, but the unloaded Q increases. Regarding the mean crystal grain size, there is noted an abrupt growth of grains, from 2 μm to 12.5 μm, at temperatures between 1,580°C and 1,590°C, the grain size gradually increasing thereafter with increasing sintering temperature.

As regards the relationship between the unloaded Q and the mean crystal grain size, the abrupt grain growth coincides with the improvement of the unloaded Q, the effect being that the larger the grain size is, the higher the unloaded Q. On the other hand, in the case of the mean crystal grain size smaller than 5 μm, no difference is noted in unloaded Q as compared with the sample No. 5 prepared based on the conventional concept that the lattice strain is caused by ordering through low-temperature, long-hour sintering.

Although not shown in Table 1 and Figure 1, in the case of samples sintered at temperatures exceeding 1,600°C, the mean crystal grain size is larger than 20 μm, and since Zn evaporates rapidly and therefore dense ceramics cannot be obtained (polarity exceeds 7%), the unloaded Q deteriorates and the relative dielectric constant (εr) decreases.

As can be seen from Figure 3, the degree of regularity reaches an almost completed level after two hours of sintering, and no change is noted even if the sintering time is lengthened. At this time, the separation between (422) and (226),

representing the lattice strain shown in Figure 4, is also clearly observed after two hours of sintering, and almost no change is noted even if the sintering time is lengthened.

Also, as can be seen from Figure 3, the unloaded Q is improved as the sintering time becomes longer, reaching a maximum of 27,000 at 30 hours, but drops thereafter to the lowest level at 120 hours. On the other hand, the mean crystal grain size increases to 0.1 μm after two hours of sintering and becomes larger as the sintering time becomes longer, reaching 24 μm at 120 hours. As regards the relationship between the unloaded Q and the mean crystal grain size, the unloaded Q becomes larger as the mean crystal grain size grows up to about 15 μm, but when the mean crystal grain size exceeds 15 μm, the unloaded Q begins to deteriorate since the porosity increases and dense ceramics cannot be obtained. Furthermore, when the mean crystal grain size exceeds 20 μm, the unloaded Q rapidly deteriorates and drops below the level of the sample No. 12 prepared by the prior art method using high-temperature, quick sintering and low-temperature, long-hour heat treatment. Rapid deterioration of the unloaded Q occurs if the mean crystal grain size becomes larger than 20 μm or if the porosity becomes greater than 7%. The porosity should preferably be 7% or less in view of hardness, workability, etc.

On the other hand, when the mean crystal grain size is smaller than 5 μm, the unloaded Q is lower than that of the sample No. 12 prepared by the conventional method. It is believed, though the detailed cause is unknown, that with the mean crystal grain size of 5 μm or over, the effect of the grain boundary with respect to the entire sintered body decreases with a resultant reduction in the effect of the crystalline disorder at the grain boundary, thereby enhancing the crystallinity as the entire sintered body and thus increasing the unloaded Q.

It has therefore been proved that in the high-frequency dielectric ceramics containing an oxide of complex perovskite structure according to claim 1 as the main component, a greater effect is produced for improvement of the unloaded Q when the mean crystal grain size of the sintered ceramics is controlled to within the range of 5 μm to 20 μm and the porosity not exceeding 7% than when the lattice strain is caused by regulating the said B1 and B2 ions based on the conventional concept. This means that although by enhancing the regularity of the long-range periodic arrangement of the B1 and B2 ions it may be improved and the associated generation of lattice strain, the unloaded Q is much more dependent on the mean crystal grain size of the sintered ceramics.

Therefore, in the high-frequency dielectric ceramics containing an oxide of complex perovskite structure according to claim 1 as the main component, the mean crystal grain size of the sintered ceramics is controlled to within the range of 5 μm to 20 μm and the porosity not exceeding 7%.

Example 2

High purity $BaCO_3$, MgO, $Ta_2O_5$, ZnO, and $Nb_2O_5$ were weighed out to give the compositions shown in Table 2-1 when expressed by the formula uBaO·v[XMgO, (1-x) ZnO]·w[y$Nb_2O_5$, (1-y) $Ta_2O_5$]. The powder was prepared and compacted in the same manner as in Example 1. The sample ceramics were produced by sintering the compacts at temperature of 1,400 to 1,600°C for 2 to 24 hours (at a heating/cooling rate of 200°C/h).

Table 2-1

| Sample Nos | Compositions | | | | |
|---|---|---|---|---|---|
| | u | v | w | x | y |
| 13 | 0.590 | 0.205 | 0.205 | 0.5 | 0.5 |
| 14 | 0.590 | 0.205 | 0.205 | 0.2 | 0.9 |
| *15 | 0.590 | 0.205 | 0.205 | 0.2 | 0.9 |
| 16 | 0.605 | 0.180 | 0.215 | 0 | 0 |
| 17 | 0.605 | 0.180 | 0.215 | 0 | 1 |
| *18 | 0.605 | 0.180 | 0.215 | 0 | 1 |
| 19 | 0.615 | 0.180 | 0.205 | 0.8 | 0.8 |
| 20 | 0.615 | 0.180 | 0.205 | 0.9 | 0.2 |
| *21 | 0.615 | 0.180 | 0.205 | 0.9 | 0.2 |
| *22 | 0.625 | 0.175 | 0.200 | 0.8 | 0.2 |
| *23 | 0.610 | 0.200 | 0.190 | 0.5 | 0.5 |
| *24 | 0.590 | 0.185 | 0.225 | 1 | 0 |
| *25 | 0.575 | 0.220 | 0.205 | 0.2 | 0.2 |

Next, the mean crystal grain size, porosity, relative dielectric constant (εr), unloaded Q, and temperature characteristic (τf) of resonant frequency of the thus produced samples were measured in the same manner as in Example 1, the results of which are shown in Table 2-2. In Tables 2-1 and 2-2, the sample numbers marked with "*" indicate the samples outside the scope of the present invention.

Table 2-2

| Sample Nos | Mean crystal grain size (µm) | Porosity (%) | Unloaded (Q) | Relative dielectric constant (εr) | Temperature characteristic τf (ppm/°C) |
|---|---|---|---|---|---|
| 13 | 8.7 | 3.4 | 16000 | 29.5 | 6.2 |
| 14 | 14.3 | 3.8 | 14200 | 33.2 | 9.4 |
| *15 | 18.4 | 8.6 | 7500 | 28.2 | 7.7 |
| 16 | 15.5 | 4.5 | 19800 | 29.8 | -1.2 |
| 17 | 17.0 | 5.9 | 13100 | 30.4 | 7.6 |
| *18 | 3.8 | 2.8 | 8900 | 33.5 | 8.0 |
| 19 | 11.1 | 6.4 | 15500 | 30.5 | 7.9 |
| 20 | 15.9 | 2.6 | 23200 | 25.7 | 5.4 |
| *21 | 24.6 | 8.1 | 8200 | 22.8 | 3.1 |
| *22 | | | unsintered | | |
| *23 | 9.4 | 6.8 | 6300 | 26.4 | 5.3 |
| *24 | 12.8 | 4.1 | 3400 | 22.9 | 2.1 |
| *25 | 6.9 | 2.2 | 7100 | 29.4 | 0.5 |

As can be seen from Table 2-2, high-frequency dielectric ceramics having a high unloaded Q can be obtained using the compositions within the scope of the present invention when the mean crystal grain size of the sintered ceramics is controlled to within the range of 5 µm to 20 µm and the porosity not exceeding 7%.

When $u>0.620$ or $w<0.190$, the composition shows poor sintering, e.g., the sample No. 22 was unsintered. When $u<0.585$ or $w>0.220$, low unloaded Q, low relative dielectric constant ( £r), and increased temperature characteristic (τf) of resonant frequency result, which renders the composition unsuitable for practical use. Therefore, such compositions were excluded from the scope of the present invention.

Also, when the mean crystal grain size of the sintered ceramics is larger than 20 µm or when the porosity is greater than 7% even if the mean crystal grain size is within the range prescribed in the present invention, the unloaded Q deteriorates. Therefore, such compositions were excluded from the scope of the present invention.

Moreover, when the mean crystal grain size is smaller than 5 µm, no difference is noted from the prior art. Therefore, such compositions were excluded from the scope of the present invention.

Example 3

High purity $BaCO_3$, MgO, and $Ta_2O_5$ were weighed out so that the ceramics of the compositions shown in Table 3 could be obtained, and the thus weighed materials were wet-mixed using a ball mill. The mixture was pre-sintered at 1,000 to 1,200°C for 2 hours and wet-ground using a ball mill, followed by dehydration and drying. Thereafter, a binder was added to the resulting powder to control the grain size thereof, and the thus prepared powder was dry-pressed at a pressure of 1,000 kg/cm$^2$ to form into disks of 7.5 mm in diameter and 4.0 mm in thickness. The thus formed compacts were then sintered under conventional sintering conditions (heating/cooling rate: 200°C/h, sintering temperature: 1,500 to 1,600°C, sintering time: 2 to 24 hours), to obtain the sample ceramics.

The relative dielectric constant (εr), unloaded Q, and temperature characteristic (τf) of resonant frequency of the thus obtained samples were measured at the resonant frequency of 10GHz, the results of which are shown in Table 3.

Table 3

| Sample Nos | Composition (wt%) | | | Unloaded Q | Relative dielectric constant | Temperature characteristic |
|---|---|---|---|---|---|---|
| | BaO | MgO | $Ta_2O_5$ | | (ε r) | τf (ppm/°C) |
| 26 | 48.75 | 4.25 | 47.00 | 24200 | 24.5 | +2.6 |
| 27 | 48.75 | 3.85 | 47.40 | 18500 | 23.9 | +1.5 |

Continuation of the Table on the next page

Table 3 (continued)

| Sample Nos | Composition (wt%) | | | Unloaded Q | Relative dielectric constant | Temperature chracteristic |
|---|---|---|---|---|---|---|
| | BaO | MgO | $Ta_2O_5$ | | (ε r) | τf (ppm/°C) |
| 28 | 48.35 | 3.85 | 47.80 | 9400 | 24.0 | +4.2 |
| 29 | 48.35 | 4.25 | 47.40 | 20600 | 24.4 | -0.4 |
| 30 | 48.60 | 4.10 | 47.20 | 27500 | 24.9 | -1.6 |
| 31 | 48.50 | 4.00 | 47.50 | 29800 | 24.9 | -3.1 |
| 32 | 48.75 | 4.45 | 46.80 | 8700 | 23.6 | -3.2 |
| 33 | 48.50 | 4.40 | 47.10 | 9100 | 24.5 | -1.1 |
| 34 | 48.15 | 4.45 | 47.40 | 7800 | 23.9 | -0.3 |
| 35 | 48.15 | 4.05 | 47.80 | 6700 | 22.1 | +3.7 |
| 36 | 48.20 | 3.70 | 48.10 | 6800 | 23.0 | +8.7 |
| 37 | 48.70 | 3.70 | 47.60 | 8700 | 24.3 | +4.6 |
| *38 | 48.90 | 4.40 | 46.70 | unsintered | | |
| *39 | 48.60 | 4.70 | 46.70 | 900 | 16.4 | -2.0 |
| *40 | 48.05 | 4.70 | 47.25 | 1800 | 19.2 | +4.8 |
| *41 | 47.90 | 3.85 | 48.25 | 1300 | 21.5 | +24.0 |
| *42 | 48.10 | 3.50 | 48.40 | 4800 | 23.1 | +42.0 |
| *43 | 48.80 | 3.40 | 47.80 | 2000 | 14.0 | +20.2 |
| *44 | 48.95 | 3.65 | 47.40 | unsintered | | |
| *45 | 48.82 | 4.28 | 46.90 | unsintered | | |

In Table 3, the sample numbers marked with "*" indicate the samples outside the scope of the present invention.

Figure 5 is a triangular diagram showing the composition ranges, III and IV, of the present invention. The numbers in Figure 5 correspond to the sample numbers in Table 3 and represent the compositions of the corresponding samples.

As is apparent from Table 3, it is obvious that within the scope of the composition range III, ceramics of high unloaded Q can be obtained using a conventional sintering method. Among others, within the scope of the composition range IV, ceramics of particularly high unloaded Q can be obtained. Examination by X-ray diffraction showed that the regularity of arrangement reached an almost completed level after a short-time sintering of 2 hours at 1,600°C.

Regarding those outside the above scopes, if BaO exceeds 48.8 wt%, no sintering occurs (sample Nos. 38, 44, 45), and if it is less than 48.1 wt%, the unloaded Q is low and the temperature characteristic (τf) increases (sample Nos. 40, 41). Also, if MgO exceeds 4.5wt%, the sintering characteristics deteriorate, resulting in a reduced relative dielectric constant (εr) and a low unloaded 0 (sample Nos. 39, 40). On the other hand, if it is less than 3.6 wt%, the temperature characteristic (τf) increases (sample Nos. 42, 43). Because of these and other shortcomings, such compositions do not satisfy the object of the present invention.

According to the composition range III, sintering characteristics are dramatically improved and a high degree of densification is readily and stably achieved using a conventional sintering method; therefore, dielectric ceramics containing a complex perovskite compound as the main component and having a high unloaded Q of 5,000 or over at 11GHz can be obtained.

When the composition range is restricted to the composition range IV, the high density (higher than 97% of theoretical density) ceramics can reach a sufficient level of regularity with a very short heat treatment of 10 minutes to 50 hours. As a result, dielectric ceramics containing a complex perovskite compound as the main component and having an unloaded Q of 10,000 or over at 11GHz can be obtained without requiring heat treatment of long duration.

It was also confirmed within the composition range III that the sintering characteristics can be improved by adding a small amount of additive, without causing substantial deterioration of the material properties. For example, when 0.02 wt% $SiO_2$ was added to the sample No. 32, no substantial change in the properties was noted although the sintering temperature dropped by about 80°C. The same effects can be expected of other additives.

Powder composed of the theoretical composition of $Ba(Mg_{1/3}Ta_{2/3})O_3$, a composition outside the composition range III, was prepared under the same conditions as above and a plurality of compacts were sintered by the rapid heating method and subjected to heat treatment. The resulting samples showed a large variation in the sintered density along with the formation of cracks, causing the unloaded Q to vary over a wide range of 2,000 to 18,000. On the other hand, when a plurality of compacts having the same composition as the sample No. 31 were sintered using a conventional sintering method, a high and stable unloaded Q of 28,000 to 32,000 was obtained.

## Claims

1. A dielectric ceramic containing as its main component the oxide of a complex perovskite structure and having a mean crystal grain size of sintered ceramic controlled to within the range of 5 μm to 20 μm and a porosity not exceeding 7%,
said oxide of the complex perovskite structure consisting essentially of a compound represented by the formula: uBaO·v[xMgO, (1-x)ZnO]·w [$YNb_2O_5$, (1-y)$Ta_2O_5$], wherein $0 \leqq x \leqq 1$, $0 \leqq y \leqq 1$, $0.585 \leqq u \leqq 0.620$, $0.160 \leqq v \leqq 0.220$, $0.195 \leqq w \leqq 0.220$, and u+v+w=1.

2. A dielectric ceramic containing as its main component an oxide of a complex perovskite structure and having a mean crystal grain size of sintered ceramic controlled to within the range of 5 μm to 20 μm and a porosity not exceeding 7 %,
wherein said oxide of the complex perovskite structure consists essentially of a compound represented by the formula: $Ba[(Mg_x Zn_{1-x})_{1/3} -Nb_y Ta_{1-y})_{2/3}]O_3$, wherein $0 \leqq x \leqq 1$, $0 \leqq y \leqq 1$.

3. A dielectric ceramic containing as its main component a complex perovskite compound consisting essentially of BaO, MgO, and $Ta_2O_5$, the composition range thereof being in the range of 48.1 to 48.8 % by weight for BaO and in the range of 3.6 to 4.5 % by weight for MgO, and the remaining percentage for $Ta_2O_5$ in the range of 46.7 to 48.3 % by weight.

4. A dielectric ceramic as claimed in claim 3, wherein the complex perovskite compound consist essentially of BaO, MgO, and $Ta_2O_5$, the composition range thereof being in the range of 48.3 to 48.8 % by weight for BaO and in the range of 3.8 to 4.3 % by weight for MgO, and the remaining percentage for $Ta_2O_5$ in the range of 46.9 to 47.7 % by weight.

## Patentansprüche

1. Dielektrische Keramik, die als Hauptbestandteil das Oxid einer komplexen Perovskit-Struktur enthält und eine mittlere Kristallkorngröße der gesinterten Keramik, die gesteuert in den Bereich von 5 μm bis 20 μm gebracht wird, und eine Porosität hat, die 7% nicht übersteigt,
wobei das Oxid der komplexen Perovskit-Struktur im wesentlichen aus einer Zusammensetzung besteht, die durch die folgende Formel wiedergegeben wird: uBaO · v [xMgO, (1-x)ZnO] · w [$YNb_2O_5$, (1-y)$Ta_2O_5$], mit $0 \leq x \leq 1$, $0 \leq y \leq 1$, $0{,}585 \leq u \leq 0{,}620$, $0{,}160 \leq v \leq 0{,}220$, $0{,}195 \leq w \leq 0{,}220$ und u+v+w=1.

2. Dielektrische Keramik, die als Hauptbestandteil ein Oxid einer komplexen Perovskit-Struktur enthält und eine mittlere Kristallkorngröße der gesinterten Keramik, die gesteuert in den Bereich von 5 μm bis 20 μm gebracht wird, und eine Porosität hat, die 7% nicht übersteigt,
wobei das Oxid der komplexen Perovskit-Struktur im wesentlichen aus einer Zusammensetzung besteht, die durch die folgende Formel wiedergegeben wird: $Ba [Mg_x Zn_{1-x})_{1/3} (Nb_y Ta_{1-y})_{2/3}]O_3$, mit $0 \leq x \leq 1$, $0 \leq y \leq 1$.

3. Dielektrische Keramik, die als Hauptbestandteil eine komplexe Perovskit-Verbindung enthält, die im wesentlichen aus BaO, MgO und $Ta_2O_5$ besteht, wobei ihr Zusammen-setzungsverhältnis im Bereich von 48,1 bis 48,8 Gew.-% für BaO und im Bereich von 3,6 bis 4,5 Gew.-% für MgO und der verbleibende Prozentsatz für $Ta_2O_5$ im Bereich von 46,7 bis 48,3 Gew.-% liegen.

4. Dielektrische Keramik, wie im Anspruch 3 beansprucht, bei der die komplexe Perovskit-Verbindung im wesentlichen aus BaO, MgO und $Ta_2O_5$ besteht, wobei deren Zusammensetzungsverhältnis im. Bereich von 48,3 bis 48,8 Gew.-% für BaO und im Bereich von 3,8 bis 4,3 Gew.-% für MgO und der verbleibende Prozentsatz für $Ta_2O_5$ im Bereich von 46,9 bis 47,7 Gew.-% liegen.

## Revendications

1. Céramique diélectrique contenant comme composant principal un oxyde de structure de perovskite complexe et ayant une granulométrie moyenne des cristaux de céramique frittée réglée de façon à se trouver dans la plage comprise entre 5 μm et 20 μm, et une porosité ne dépassant pas 7 %,
ledit oxyde de structure de perovskite complexe étant essentiellement un composé représenté par la formule:

$uBaO \cdot v[xMgO, (1-x) \cdot ZnO].w[YNb_2O_5, (1-y) Ta_2O_5]$, dans laquelle $0 \leq x \leq 1$, $0 \leq y \leq 1$, $0,585 \leq u \leq 0,620$, $0,160 \leq v \leq 0,220$, $0,195 \leq w \leq 0,220$, et $u+v+w=1$.

**2.** Céramique diélectrique contenant comme composant principal un oxyde de structure de perovskite complexe et ayant une granulométrie moyenne des cristaux de céramique frittée réglée de façon à se trouver dans la plage comprise entre 5 µm et 20 µm, et une porosité ne dépassant pas 7 %,

dans laquelle ledit oxyde de structure de perovskite complexe consiste essentiellement en un composé représenté par la formule: $Ba[Mg_xZn_{1-x})_{1/3} (Nb_y Ta_{1-y})_{2/3}]O_3$, dans laquelle $0 \leq x \leq 1$, $0 \leq y \leq 1$.

**3.** Céramique diélectrique contenant comme composant principal un composé de perovskite complexe consistant essentiellement en BaO, MgO, et $Ta_2O_5$, la plage de composition de celui-ci se trouvant dans la plage comprise entre 48,1 et 48,8 % en poids pour BaO, et dans la plage comprise entre 3,6 et 4,5 % en poids pour MgO, et le pourcentage restant pour $Ta_2O_5$ dans la plage comprise entre 46,7 et 48,3 % en poids.

**4.** Céramique diélectrique selon la revendication 3, dans laquelle le composé de perovskite complexe consiste essentiellement en BaO, MgO et $Ta_2O_5$, la plage de composition de celui-ci se trouvant dans la plage comprise entre 48,3 et 48,8 % en poids pour BaO, et dans la plage comprise entre 3,8 et 4,3 % en poids pour MgO, et le pourcentage restant pour $Ta_2O_5$ dans la plage comprise entre 46,9 et 47,7 % en poids.

Fig. 1

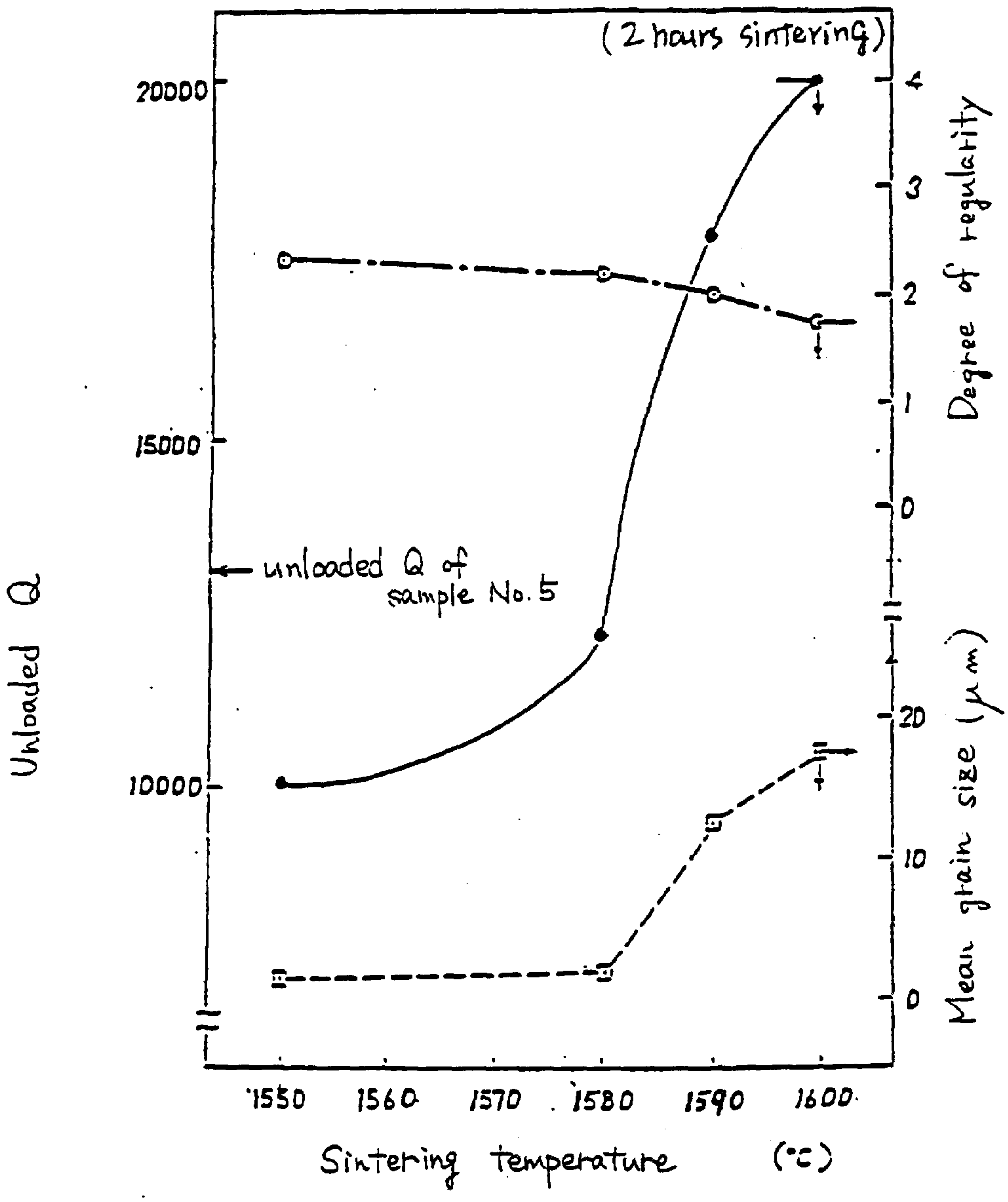
(2 hours sintering)
Unloaded Q
20000
15000
10000
unloaded Q of sample No. 5
Degree of regularity
4
3
2
1
0
Mean grain size (μm)
20
10
0
1550
1560
1570
1580
1590
1600
Sintering temperature (°C)

Fig. 2

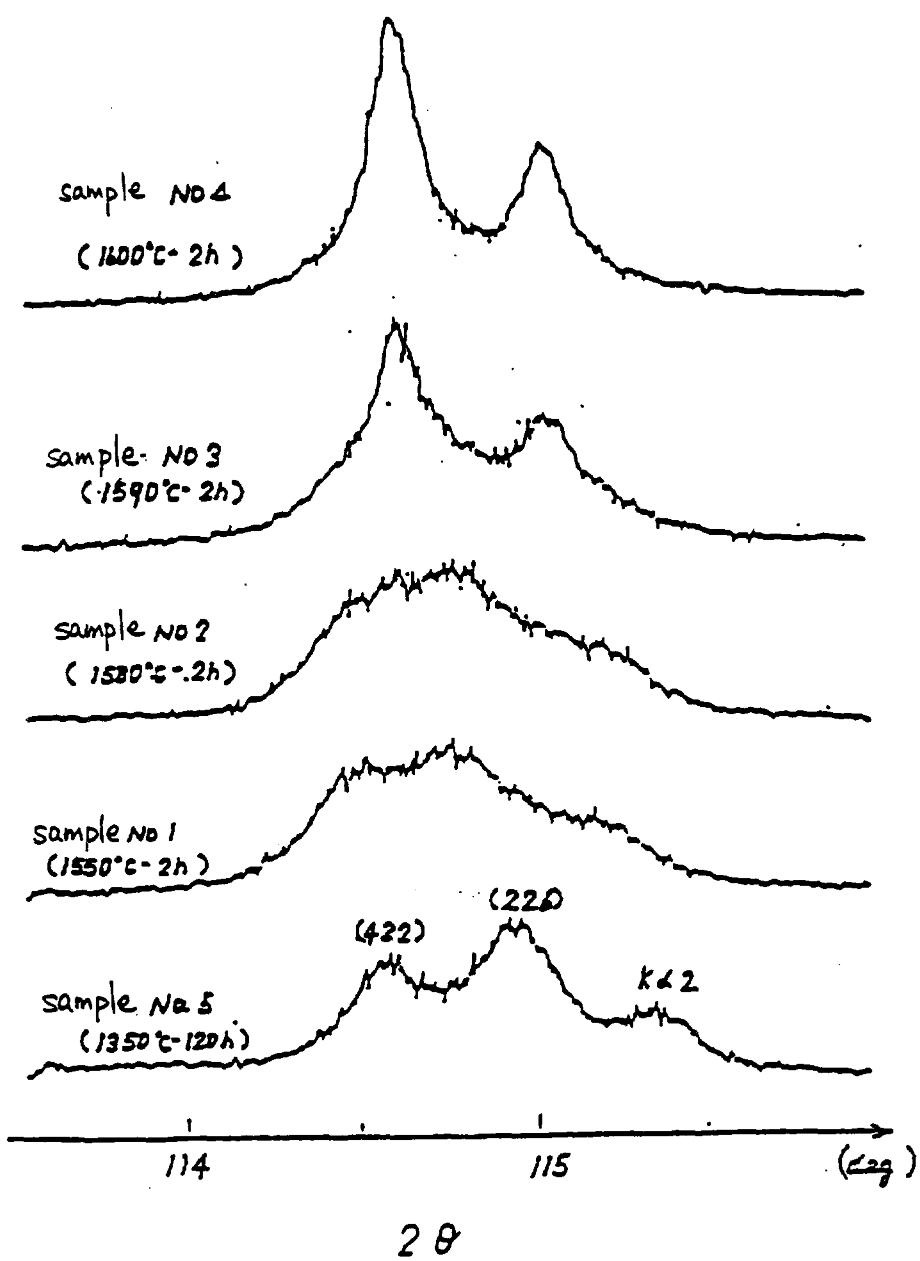
sample NO4
(1600°C-2h)
sample NO3
(1590°C-2h)
sample NO2
(1580°C-2h)
sample NO1
(1550°C-2h)
sample No5
(1350°C-120h)
(422)
(220)
Kα2
114
115
(deg)
2θ

Fig. 3

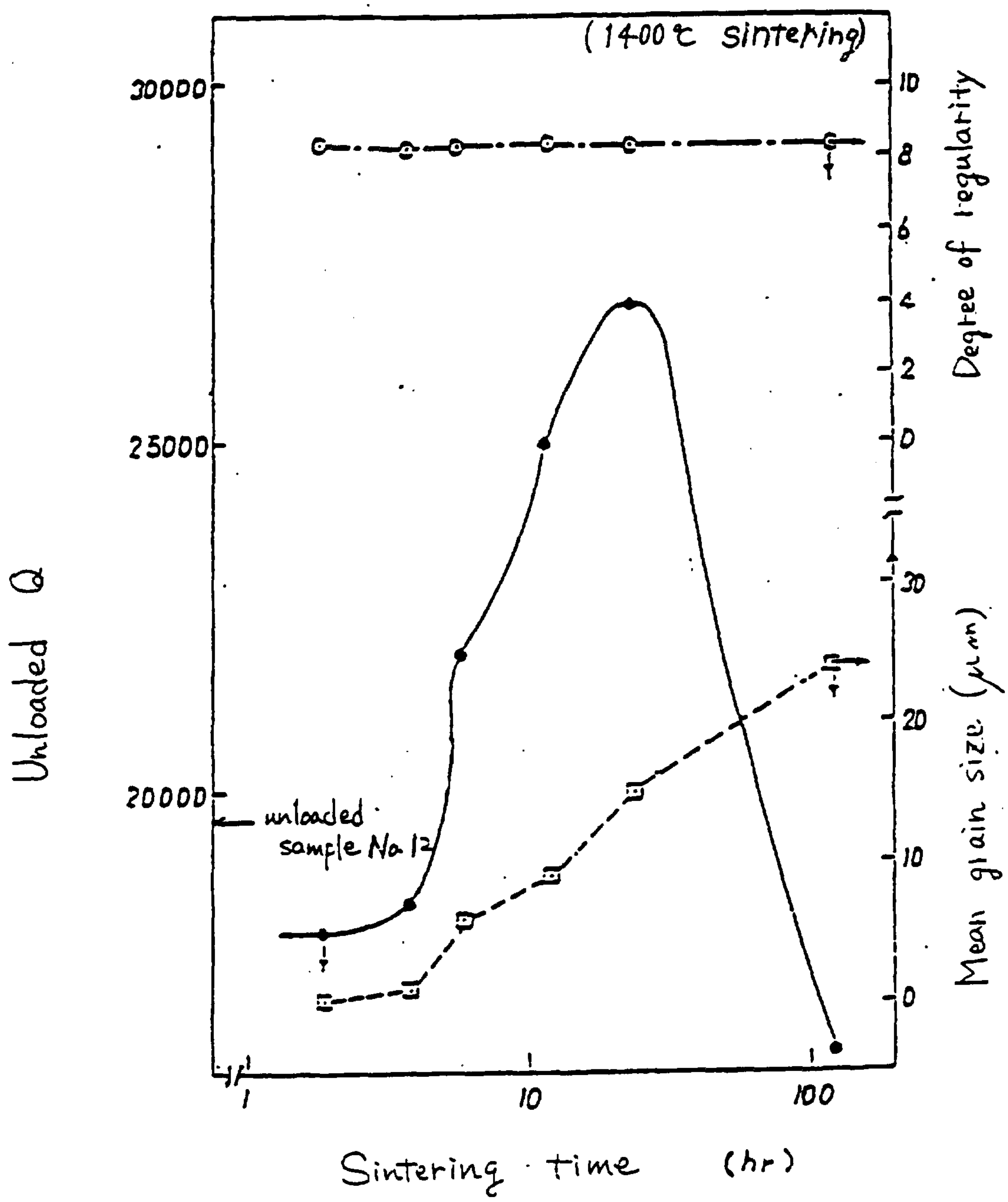
(1400℃ sintering)
30000
25000
20000
Unloaded Q
unloaded sample No 12
10
8
6
4
2
0
Degree of irregularity
30
20
10
0
Mean grain size (μm)
1
10
100
Sintering time (hr)

Fig. 4

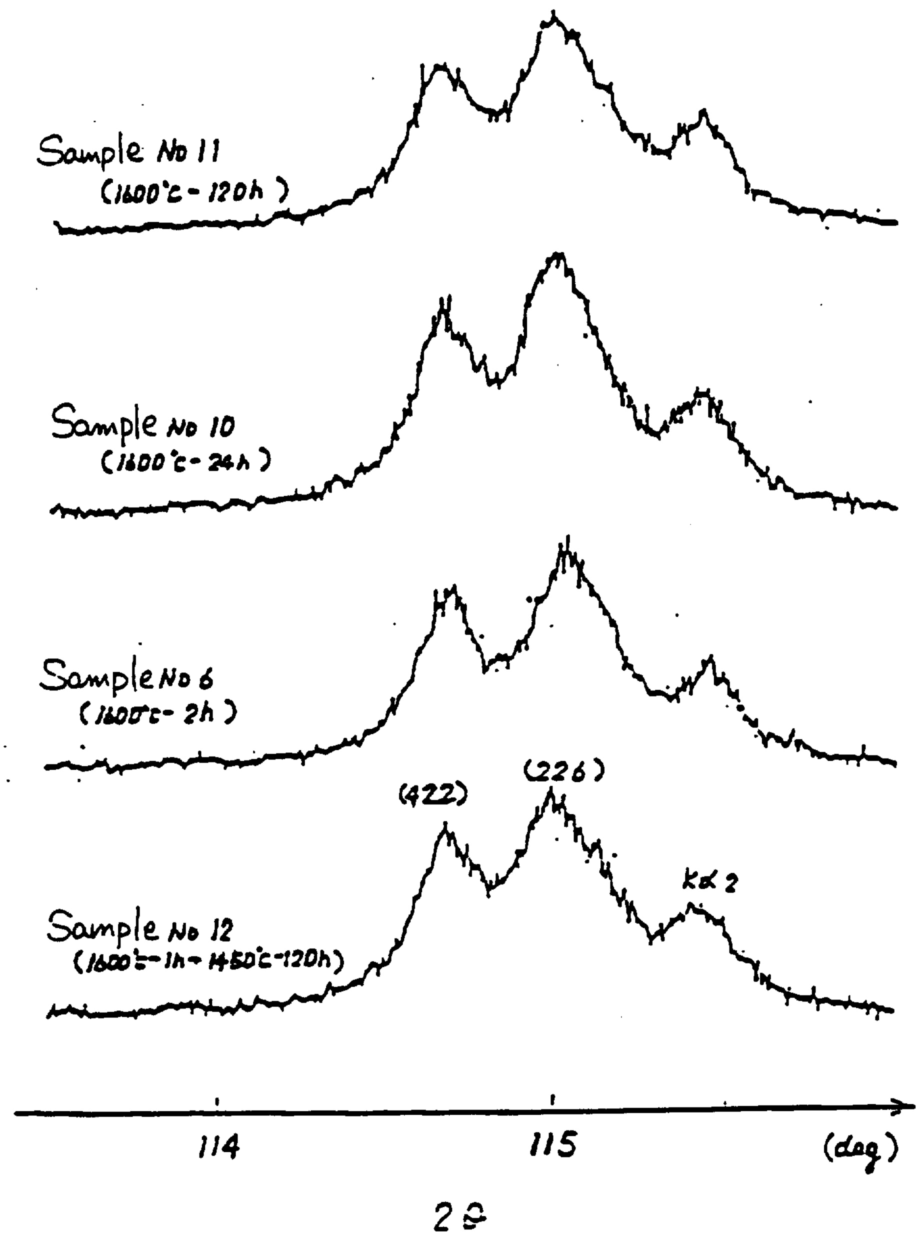
Sample No 11
(1600°c - 120h)
Sample No 10
(1600°c - 24h)
Sample No 6
(1600°c - 2h)
Sample No 12
(1600°c-1h-1450°c-120h)
(422)
(226)
Kα 2
114
115
(deg)
2θ

Fig. 5

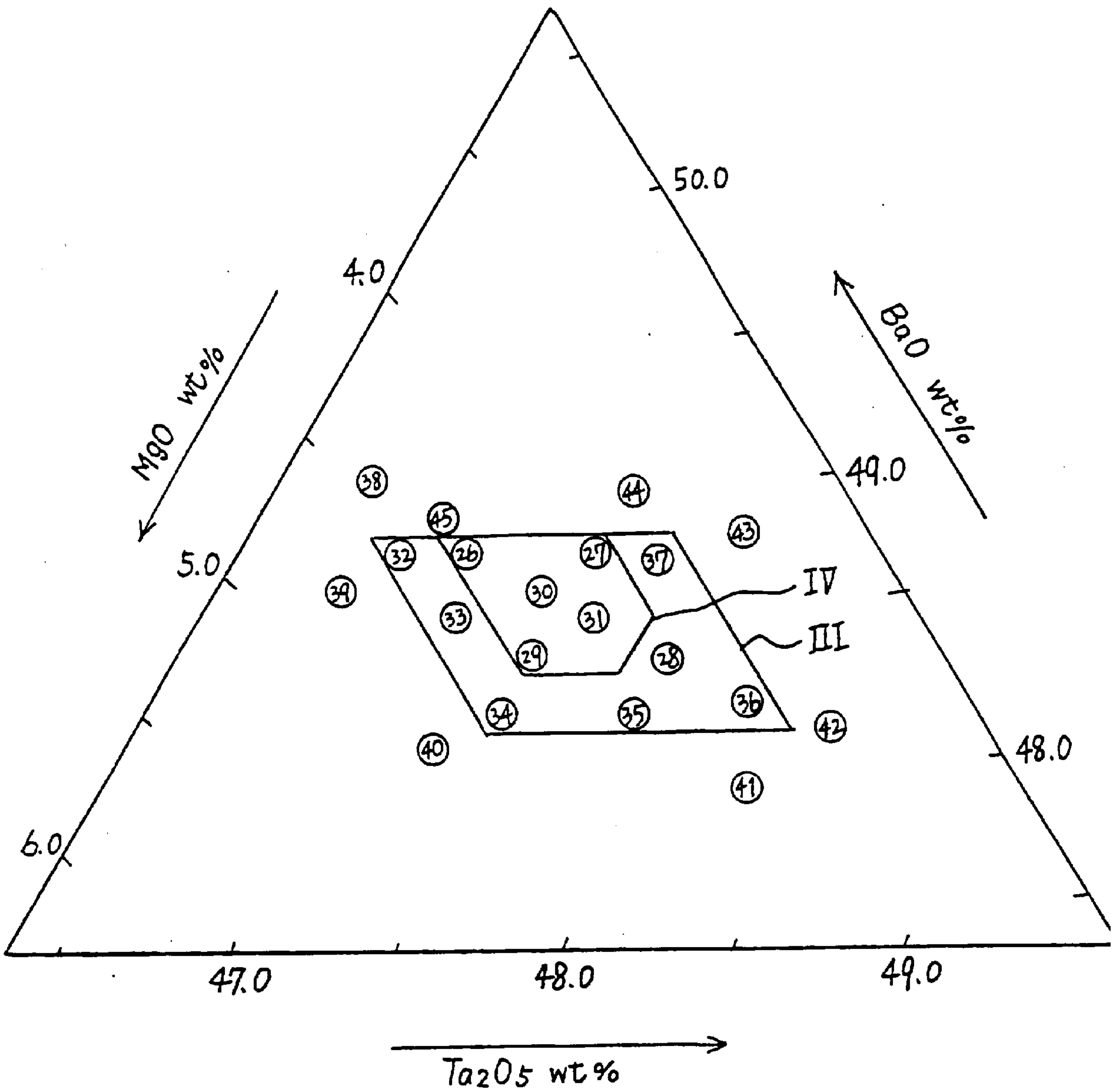
50.0
4.0
BaO wt%
MgO wt%
49.0
38
44
45
43
32
26
27
37
5.0
IV
39
30
31
33
III
29
28
36
34
35
42
48.0
40
41
6.0
47.0
48.0
49.0
Ta2O5 wt%